# EUROPÄISCHE PATENTSCHRIFT

(11) **EP 1 129 823 B1**
(45) Veröffentlichungstag und Bekanntmachung des Hinweises auf die Patenterteilung: **03.11.2004**
(21) Anmeldenummer: 01101549.2
(22) Anmeldetag: 24.01.2001
(51) Int. Cl.: B24C 3/32, B24C 11/00, H01L 21/304

(54) **Verfahren zur Regenerierung von Halbleiterscheiben**
Method for reworking semiconductor wafers
Procédé de régénération de plaquettes de semiconducteurs

(30) Priorität: 29.02.2000 DE 10010820
(43) Veröffentlichungstag der Anmeldung: 05.09.2001
(73) Patentinhaber: Infineon Technologies AG, 81669 München (DE)
(72) Erfinder: Krämer, Hans, Dr., 09627 Hilbersdorf (DE); Taubert, Matthias, 01445 Radbeul (DE); Loibnegger, Gernot, Dr., 01465 Langebrück (DE)
(74) Vertreter: Epping, Hermann, Fischer

(56) Entgegenhaltungen:
- US-A- 4 679 359
- US-A- 5 170 245
- US-A- 5 622 875
- US-A- 5 981 301

## Beschreibung

Die Erfindung betrifft ein Verfahren zur Regenerierung von testweise zur Prozess- und Equipmentkontrolle verwendeter oder aber mehr oder weniger oberflächenbeschädigter, meist aus Silicium bestehender Halbleiterscheiben im Rahmen der Herstellung von Schaltkreisen auf Halbleiterscheiben, wobei die Regeneration durch Entfernen der zuvor aufgetragenen Schichten geschieht.

In Chip-Produktionsstätten zur Herstellung von Elektronik-Schaltkreisen auf vorzugsweise aus Silicium bestehenden Halbleiterscheiben, durchlaufen neben den Scheiben auf denen die Chipstrukturen erzeugt werden, auch einige, meist aus Silizium bestehende Testscheiben (sog. Testwafer) den Produktionsablauf, um so eine effektive Prozess- und Equipmentkontrolle zu ermöglichen. Auf beiden Scheiben werden auf der Oberfläche dünne, aus verschiedenen Materialien bestehende Schichten aufgebracht, die strengen Anforderungen hinsichtlich der Schichtdicke, der Homogenität usw. erfüllen müssen.

Da die Schichtherstellung mit deren Strukturierung ein sehr schwieriger und kostenintensiver Prozess ist, wird versucht, die Testwafer oder aber auch stark beschädigte Scheiben später wieder zu regenerieren, und dem Prozessablauf als Testwafer wieder zuzuführen.

Es ist bekannt, auf Halbleiterscheiben aufgebrachte Silicium-Schichten durch verschiedene chemische Ätzverfahren zu bearbeiten. (DE 196 24 315 C2 und DE 197 21 493 A1). Zum einen findet die Technik des chemischen Ätzens vorwiegend Anwendung bei der Beseitigung von Unebenheiten, die im Prozess der Erstgewinnung der Halbleiteiterscheibe aus einem stabförmigen Einkristall entstanden sind (sog. damages). Zum anderen wird diese Technik auch bei der Strukturierung von auf der Halbleiterscheibe befindlichen Schichten benutzt.

Neben dieser Methode wird zur Beseitigung gröberer Unebenheiten eines Wafers auch die Technik des sogenannten Läppens zum Einsatz gebracht (DE 197 55 705). Hierbei handelt es sich um eine mechanische Oberflächenbehandlung, bei der die Halbleiterscheiben unter rotierenden Bewegungen und Zuführung von Schleifmitteln bearbeitet werden.

Es ist ferner bekannt, die genannten Verfahren auch auf den Wiedergewinnungsprozess von zu Testzwecken verwendeten Wafern einzusetzen (US 5 981 301, US 5 622 875).

Insbesondere bei mehrschichtigen und strukturierten Wafern ist das chemische Ätzen aufwendig und damit sehr kostenintensiv.
Durch die erforderliche Verwendung verschiedener Ätzlösungen und den hohen Wasserverbrauch tritt außerdem eine erhebliche Umweltbelastung ein. Das Verfahren des Läppens ist mit dem Nachteil eines hohen Zeitaufwandes behaftet.

Der Erfindung liegt damit die Aufgabe zugrunde, ein Regenerierungsverfahren für Halbleiterscheiben zu entwickeln, welches zum einen kostengünstig und umweltschonend und zum anderen weniger zeitintensiv ist.

Dieses Problem wird bei einem Verfahren der eingangs genannten Art dadurch gelöst, dass die aufgebrachten Schichten durch Nassstrahlen unter Verwendung von im Wasser fein verteiltem Strahlgut mit einer vorgegebenen und im wesentlichen gleichmäßigen Körnung entfernt werden.

Hierdurch lassen sich kostengünstig aufgebrachte Schichten entfernen, weil keine unterschiedlichen Ätzlösungen mehr eingesetzt werden müssen. Gleichzeitig wird die Umweltbelastung durch verringerte Schadstoffmengen und einen kleineren Wasserverbrauch abgesenkt.

Eine Ausführungsform sieht die Verwendung von vorwiegend aus Siliziumdioxid, Korund oder deren Gemischen bestehenden Strahlgutes vor. Diese Stoffe unterstützen den Abtragungseffekt der Nassstrahlen aufgrund ihrer für das Verfahren besonders geeigneten Beschaffenheit, insbesondere durch ihre Härte.

Eine weitere Ausführung der Erfindung sieht vor, dass ein Strahlgut mit einer Körnung <100gm verwendet wird. Dies gewährleistet eine Optimierung des Abtragungseffektes in Bezug auf die Gleichmäßigkeit der Abtragung.

Eine besonders günstige Ausführungsform sieht vor, dass die Nassstrahlen unter einem Wasserdruck zwischen 2 - 5 bar auf die Platten auftreffen. Hierdurch wird eine möglichst zielgenaue Schichtabtragung unter optimierten zeitlichen Bedingungen gewährleistet.

Eine weitere Ausführung der Erfindung sieht vor, dass die Nassstrahlen mit dem Strahlgut auf der Oberfläche in einem Winkel zwischen 60 und 90 Grad auftreffen. Auch dies trägt zu einer erhöhten Gleichmäßigkeit und Zielgenauigkeit des Abtragungsprozesses bei.

Um der für die angewandte Chipproduktion erforderlichen Oberflächengüte der Halbleiterscheiben gerecht zu werden, schließt sich ein mechanisch-chemischer Polierprozess und eine Feinreinigung an die Nassbestrahlung an.

Das erfindungsgemäße Verfahren ist leicht zu realisieren und gewährleistet einen schnellen und gleichmäßigen Schichtabtrag.

Die Erfindung soll nachfolgend anhand eines Ausführungsbeispiels näher erläutert werden.

Die beschichteten oder oberflächenbeschädigten Halbleiterscheiben treten in den Verfahrensablauf mit einer ersten visuellen Gütekontrolle ein, an die sich eine Dickemessung anschließt. Ein Verwurf der Scheibe ist bei einer Dicke > 680 *µ*m vorgesehen. Werden die Parameter für die Fortsetzung des Verfahrens erfüllt, beginnt die eigentliche Regenerierung der Scheiben in der Art, dass die aufgebrachten Schichten durch Nassstrahlen unter Verwendung von im Wasser fein verteiltem Strahlgut mit einer vorgegebenen und im wesentlichen gleichmäßigen Körnung entfernt werden. Als besonders geeignet hat sich hierbei ein aus Siliziumdioxid, Korund oder deren Gemischen bestehendes Strahlgut mit einer Körnung <100 µm erwiesen. Die Nassstrahlen mit dem Strahlgut treffen dabei unter einem Wasserdruck zwischen 2 - 5 bar und einem Winkel zwischen 60 und 90 Grad auf der Oberfläche auf. Durch gleichmäßige Bewegung der Halbleiterscheibe unter dem Strahl oder des Strahls über der Scheibe werden die Schichten auf der gesamten Oberfläche abgetragen.

Dieser Verfahrensschritt wird gegebenenfalls nach einer weiteren visuellen Kontrolle wiederholt. Sofern kein Verwurf der Halbleiterscheibe erfolgt, weil vorgegebene Parameter nicht eingehalten wurden, wird diese dann im Folgenden poliert, wobei ein Abtrag von mindestens 3 µm vorgesehen ist.

Nach dem Polieren wird der Schleifstaub entfernt ("brush clean") Im Anschluss daran erfolgt eine weitere Dickemessung. Hier ist ein Verwurf bei einer Dicke von weniger als 665 *µ*m vorgesehen.

Schließlich werden die Halbleiterscheiben einer Feinreinigung unterzogen. Wobei die Stoffe Flusssäure, SC1 und SC2 zum Einsatz kommen. Die abschließende Defektdichtebestimmung ist maßgebend für die Sortierung der Scheiben in das Testscheibenlager.

## Patentansprüche

1. Verfahren zur Regenerierung von Halbleiterscheiben, die zur Prozeß- und Equipmentkontrolle verwendet werden, und zur Regenerierung anderer Halbleiterscheiben mit beschädigter Oberfläche, wobei die Regenerierung durch Entferner von Schichten erfolgt, die zuvor im Rahmen der Herstellung von Halbleiterschaltkreisen auf die Halbleiterscheiben aufgebracht worden sind, **dadurch gekennzeichnet, dass** das Entfernen von Schichten durch Nassstrahlen unter Verwendung von im Wasser fein verteiltem Strahlgut mit einer vorgegebenen und im wesentlichen gleichmäßigen Körnungt erfolgt.

2. Verfahren nach Anspruch 1, **dadurch gekennzeichnet, dass** als Strahlgut eine Substanz mit den Hauptbestandteilen Siliziumdioxid, Korund oder deren Gemischen verwendet wird.

3. Verfahren nach einem der Ansprüche 1 oder 2, **dadurch gekennzeichnet, dass** ein Strahlgut mit einer Körnung <100 µm verwendet wird.

4. Verfahren nach einem der Ansprüche 1 bis 3, **dadurch gekennzeichnet, dass** ein Wasserdruck zwischen 2 - 5 bar eingestellt wird.

5. Verfahren nach einem der Ansprüche 1 bis 4, **da-durch gekennzeichnet, dass** ein vorgegebener Winkel, mit dem die Nassstrahlen mit dem Strahlgut auf der Oberfläche auftreffen, eingestellt wird.

6. Verfahren nach Anspruch 5, **dadurch gekennzeichnet, dass** der Winkel, mit dem die Nassstrahlen mit dem Strahlgut auf der Oberfläche auftreffen, so gewählt wird, dass er zwischen 60 und 90 Grad liegt.

7. Verfahren nach einem der Ansprüche 1 bis 6, **da-durch gekennzeichnet, dass** die nassgestrahlte Halbleiterscheibe anschließend zur Herstellung der für die angewandten Prozesse in der Chipproduktion erforderlichen Oberflächengüte mechanisch-chemisch poliert wird.

8. Verfahren nach einem der Ansprüche 1 bis 7, **dadurch gekennzeichnet, dass** die Halbleiterscheibe einer Feinreinigung unterzogen wird.

9. Verfahren nach einem der Ansprüche 1 bis 8, **dadurch gekennzeichnet, dass** die Feinreinigung mit den Stoffen HF, SC1, SC2 erfolgt.

## Claims

1. Method for regenerating semiconductor wafers which are used for process and equipment control purposes and for regenerating other semiconductor wafers with a damaged surface, the regeneration taking place by removal of layers which have been previously applied to the semiconductor wafers in the context of the fabrication of semiconductor circuits, **characterized in that** the removal of layers takes place by wet blasting using blast material which is finely distributed in water and has a predetermined and essentially uniform granularity.

2. Method according to Claim 1, **characterized in that** a substance having the main constituents silicon dioxide, corundum or mixtures thereof is used as the blast material.

3. Method according to either of Claims 1 and 2, **characterized in that** a blast material having a granularity <100 µm is used.

4. Method according to one of Claims 1 to 3, **characterized in that** a water pressure of between 2 - 5 bar is set.

5. Method according to one of Claims 1 to 4, **characterized in that** a predetermined angle at which the wet blasting with the blast material impinges on the surface is set.

6. Method according to Claim 5, **characterized in that** the angle at which the wet blasting with the blast material impinges on the surface is chosen such that it lies between 60 and 90 degrees.

7. Method according to one of Claims 1 to 6, **characterized in that** the semiconductor wafer that has been subjected to wet blasting is subsequently subjected to chemical mechanical polishing in order to produce the surface quality required for the applied processes in chip production.

8. Method according to one of Claims 1 to 7, **characterized in that** the semiconductor wafer is subjected to fine cleaning.

9. Method according to one of Claims 1 to 8, **characterized in that** the fine cleaning is carried out using the substances HF, SC1, SC2.

## Revendications

1. Procédé de régénération de plaquettes à semi-conducteurs, qui sont utilisées pour le contrôle de processus et d'équipement, et de régénération d'autres plaquettes à semi-conducteurs ayant une surface qui est endommagée, la régénération s'effectuant par élimination de couches qui ont été déposées auparavant au cours de la production de circuits à semi-conducteurs sur les plaquettes à semi-conducteurs, **caractérisé en ce que** l'élimination de couches s'effectue par projection de jets humides, en utilisant du produit de projection finement réparti dans l'eau ayant une granulométrie donnée à l'avance et sensiblement uniforme.

2. Procédé suivant la revendication 1, **caractérisé en ce que** l'on utilise comme produit de projection une substance dont les constituants principaux sont le dioxyde de silicium, le corindon ou leurs mélanges.

3. Procédé suivant l'une des revendications 1 ou 2, **caractérisé en ce que** l'on utilise un produit de projection d'une granulométrie inférieure à 100 µm.

4. Procédé suivant l'une des revendications 1 à 3, **caractérisé en ce que** l'on règle la pression de l'eau entre 2 et 5 bars.

5. Procédé suivant l'une des revendications 1 à 4, **caractérisé en ce que** l'on règle un angle donné à l'avance suivant lequel les jets humides ayant le produit à projeter arrivent sur la surface.

6. Procédé suivant la revendication 5, **caractérisé en ce que** l'angle suivant lequel les jets humides ayant le produit à projeter arrivent sur la surface est choisi de manière à être compris entre 60 et 90 degrés.

7. Procédé suivant l'une des revendications 1 à 6, **caractérisé en ce que** la plaquette à semi-conducteurs ayant reçu les jets humides est polie ensuite mécanochimiquement pour la production de la qualité de surface nécessaire aux processus utilisés dans la production de puces.

8. Procédé suivant l'une des revendications 1 à 7, **caractérisé en ce qu'**on soumet la plaquette à semi-conducteurs à un nettoyage fin.

9. Procédé suivant l'une des revendications 1 à 8, **caractérisé en ce qu'**on effectue le nettoyage fin par les substances HF, SC1, SC2.
